# FASCICULE DE BREVET EUROPEEN

(11) **EP 0 430 765 B1**
(45) Date de publication et mention de la délivrance du brevet: **14.09.1994**
(21) Numéro de dépôt: 90403291.9
(22) Date de dépôt: 21.11.1990
(51) Int. Cl.: H01S 3/097, H03K 3/57

(54) **Système d'alimentation électrique impulsionnelle d'une charge, muni de moyens pour dérouter l'énergie électrique susceptible d'être réfléchie par la charge**
Impuls-Stromversorgungssystem für eine Last, mit Mitteln um die durch die Last möglicherweise reflektierte Energie abzuleiten
Pulsating electric power supply system for a load, with means of diverting the electric energy reflected by the load

(30) Priorité: 23.11.1989 FR 8915421
(43) Date de publication de la demande: 05.06.1991
(73) Titulaire: COMMISSARIAT A L'ENERGIE ATOMIQUE, 75015 Paris (FR)
(72) Inventeur: Gidon, Serge, F-26790 Tulette (FR); Hennevin, Bernard, F-69150 Decines (FR)
(74) Mandataire: Dubois-Chabert, Guy

(56) Documents cités:
- US-A- 3 211 915
- US-A- 4 405 889

## Description

La présente invention concerne un système d'alimentation électrique impulsionnelle d'une charge. Elle s'applique notamment à l'alimentation électrique impulsionnelle d'un laser à vapeur métallique, un laser à vapeur de cuivre par exemple.

On sait que dans un laser à vapeur métallique et en particulier dans un laser à vapeur de cuivre, on obtient une inversion de population en excitant la vapeur par des décharges électriques de grande puissance instantanée.

L'énergie de ces décharges provient d'un générateur d'impulsions de puissance qui comporte des moyens d'accumulation d'énergie électrique (comportant eux-mêmes un condensateur ou un ensemble de condensateurs) préalablement chargés sous une tension électrique élevée.

Ces moyens d'accumulation d'énergie électrique sont associés à des moyens de commutation par l'intermédiaire desquels ils se déchargent dans le laser.

Ces moyens de commutation peuvent être associés à un ou des étages de compression magnétique qui permettent de diminuer la largeur temporelle des impulsions parvenant au laser.

Un générateur d'impulsions de puissance est décrit dans l'article de J.K. MITTAL et al. intitulé "Design and performance of a 20 watt copper vapour laser" et publié dans J. Phys. E: Sci. Instrum. 21 (1988) pp. 388-392, auquel on se reportera.

Le générateur décrit dans cet article comporte, en tant que moyens de commutation, un thyratron.

D'autres générateurs connus comportent des dispositifs semiconducteurs de commutation (thyristors de type GTO ou transistors de type IGBT par exemple).

Pour favoriser le commutation, il est également connu d'associer à ces dispositifs semiconducteurs de commutation des éléments magnétiques saturables (inductances saturables).

A ce sujet, on pourra se reporter à l'article de H.J. BAKER et al. intitulé "An efficient laser pulser using ferrite magnetic switches" et publié dans J. Phys. E. Sci. Instrum. 21 (1988) pp. 218-224.

Les générateurs d'impulsions de puissance qui sont connus dans l'état de la technique, et donc les systèmes connus d'alimentation électrique impulsionnelle des lasers à vapeur de cuivre qui comportent ces générateurs, sont sujets à des instabilités qui se traduisent par des fluctuations de l'énergie de ces impulsions, et donc des fluctuations de l'énergie des impulsions lumineuses engendrées par les lasers.

Ces fluctuations d'énergie sont en fait dues à la variation de la tension de recharge des moyens d'accumulation d'énergie électrique. Cette variation de tension est elle-même due aux fluctuations de l'énergie électrique absorbée par le laser associé à ces moyens d'accumulation.

Cette énergie absorbée dépend beaucoup des conditions de décharge dans la vapeur du laser.

L'énergie électrique réfléchie au niveau de la "tête" du laser (vapeur, enceinte contenant cette dernière et électrodes de décharge dans la vapeur) se présente sous la forme d'une tension électrique variable aux bornes des moyens d'accumulation d'énergie électrique, tension qui, lors du cycle de charge suivant, conduit aux fluctuations mentionnées plus haut.

Dans le cas des générateurs comportant des dispositifs semi-conducteurs de commutation associés à des éléments magnétiques saturables, ces générateurs (et donc les systèmes dont ils font partie) sont de plus sujets à des instabilités qui se traduisent par une gigue c'est-à-dire une instabilité de position temporelle des impulsions électriques fournies au laser. Cette gigue est inadmissible lors de la mise en série de plusieurs lasers fonctionnant en tant qu'amplificateurs.

La présente invention a pour but de remédier aux inconvénients d'instabilité que présentent les systèmes connus d'alimentation des lasers à vapeur métallique et notamment des lasers à vapeur de cuivre, en résolvant le problème de la maîtrise de l'énergie électrique stockée dans les moyens d'accumulation que comportent ces systèmes.

Plus généralement, la présente invention vise à remédier aux inconvénients d'instabilité que présente un système d'alimentation électrique impulsionnelle d'une charge dont l'impédance n'est pas adaptée à ce système et fluctue au cours du temps (ce qui est le cas des lasers à vapeur métallique dont l'adaptation serait d'ailleurs nuisible à leurs performances) et qui réfléchit de ce fait une partie, fluctuant dans le temps, de l'énergie électrique qu'elle reçoit.

Pour remédier à ces inconvénients, le système objet de l'invention comprend des moyens pour dérouter l'énergie électrique réfléchie par la charge, de telle façon que cette énergie réfléchie ne retourne pas directement vers le générateur d'impulsions électriques (et ne retourne donc pas directement vers les moyens d'accumulation d'énergie électrique que comporte ce générateur).

De façon précise, la présente invention a pour objet un système d'alimentation électrique impulsionnelle d'une charge, conformément à la revendication 1.

Le système objet de l'invention peut comprendre en outre des moyens auxiliaires, prévus pour récupérer, au moins en partie, l'énergie électrique réfléchie et déroutée.

Les moyens d'alimentation électrique continue peuvent comprendre :
- une source de tension électrique continue, et
- des moyens de régulation de cette tension, qui alimentent le générateur,
   et les moyens auxiliaires peuvent être en outre prévus pour transférer l'énergie électrique récupérée vers la source de tension.

Les moyens auxiliaires peuvent comprendre des troisièmes moyens d'accumulation d'énergie électrique qui sont reliés au troisième bobinage.

Les moyens auxiliaires peuvent comprendre en outre des deuxièmes moyens de commutation par l'intermédiaire desquels les troisièmes moyens d'accumulation sont reliés à la source de tension.

Les premiers et deuxièmes moyens de commutation peuvent être des dispositifs semiconducteurs de commutation.

De préférence, le générateur comprend en outre des moyens de compression magnétique par l'intermédiaire desquels la charge reçoit l'impulsion électrique.

Ces moyens de compression magnétique peuvent être reliés, d'un côté, aux deuxièmes moyens d'accumulation d'énergie électrique et, de l'autre, à la charge.

Enfin, cette charge peut être un laser à vapeur métallique.

La présente invention sera mieux comprise à la lecture de la description suivante, d'exemples de réalisation donnés en référence aux dessins annexés sur lesquels :
- la figure 1 est un schéma fonctionnel d'un système conforme à l'invention,
- la figure 2 est un schéma électrique d'un mode de réalisation particulier du système objet de l'invention, et
- la figure 3 est un schéma électrique partiel d'une variante de réalisation du système représenté sur la figure 2.

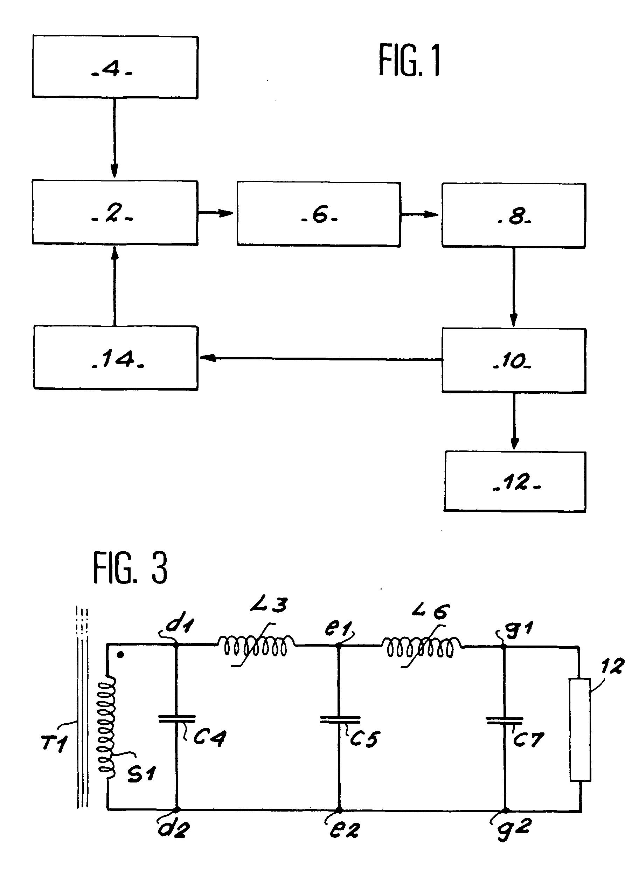

Le système conforme à l'invention, dont le schéma fonctionnel est représenté sur la figure 1, comprend successivement une source de tension électrique continue 2, qui est alimentée par une source d'énergie électrique 4, un régulateur de cette tension 6, un générateur d'impulsions 8, qui est alimenté par le régulateur 6, et des moyens 10 pour dérouter l'énergie électrique réfléchie par une charge désadaptée 12 à laquelle le générateur envoie des impulsions électriques.

Le système dont le schéma est représenté sur la figure 1 comprend aussi des moyens 14 prévus pour récupérer l'énergie électrique réfléchie par la charge 12 et déroutée et pour envoyer cette énergie réfléchie et déroutée à la source de tension 2.

De préférence, la récupération de l'énergie réfléchie est contrôlée, c'est-à-dire que, de préférence, on ne la récupère pas totalement mais qu'on n'en récupère qu'une quantité déterminée (voir plus loin).

On voit donc que, dès son apparition, l'énergie réfléchie est aiguillée vers un chemin différent de celui qui est suivi par l'énergie incidente, pour aboutir aux moyens de récupération 14, en contournant notamment le régulateur de tension 6 et le générateur d'impulsions 8, ce qui permet au régulateur 6 et au générateur 8 de travailler dans de bonnes conditions sans être perturbés.

De ce fait, les impulsions électriques fournies par le générateur 8 sont très stables en énergie et en position temporelle.

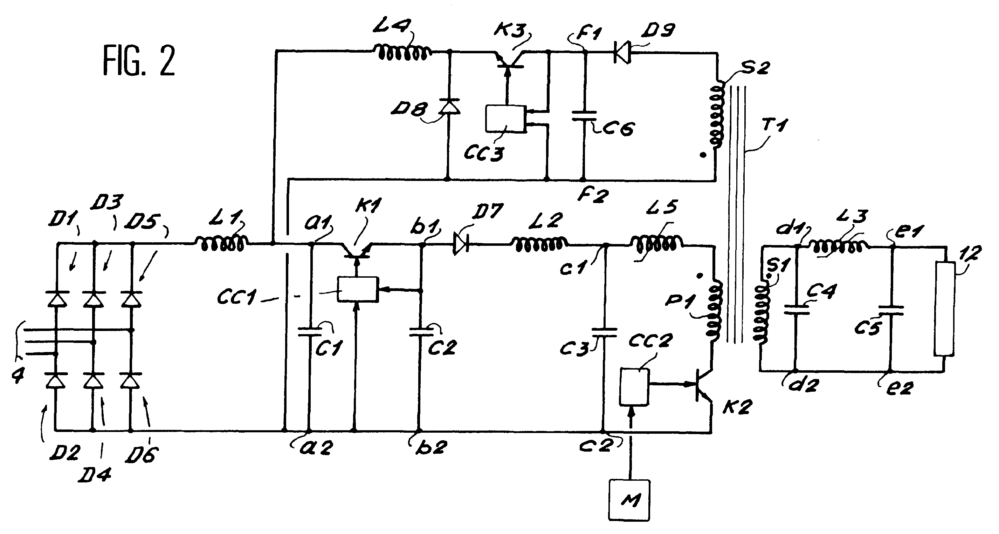

Sur la figure 2, un exemple de réalisation de l'invention est représenté sous forme d'un schéma électrique dans lequel on retrouve les divers composants du système représenté sur la figure 1.

Sur la figure 2, la source d'énergie 4 est le réseau triphasé et la charge 12 est par exemple un laser à vapeur de cuivre.

La source de tension continue 2 comprend six diodes D1 à D6, une inductance L1 et un condensateur C1. Les cathodes des diodes D2, D4 et D6 sont respectivement reliées aux anodes des diodes D1, D3 et D5 dont les cathodes sont reliées à une borne de l'inductance L1. L'autre borne de L1 est reliée à une borne a1 du condensateur C1 dont l'autre borne a2 est reliée aux anodes des diodes D2, D4 et D6. Les trois conducteurs du réseau triphasé 4 sont respectivement reliés aux anodes des diodes D1, D3 et D5.

On obtient ainsi une source de tension filtrée mais non stabilisée.

On stabilise la tension continue ainsi obtenue et on améliore son filtrage au moyen d'un transistor K1 et d'un condensateur C2 et l'amplitude de cette tension est ensuite doublée au moyen d'un circuit oscillant comprenant une inductance L2 et un condensateur C3 qui constitue ici les moyens d'accumulation de l'énergie électrique que l'on veut envoyer à la charge 12.

Le transistor K1 est par exemple un transistor IGBT de type NPN. Il est associé à une carte de commande CC1, qui commande le transistor K1 en tout ou rien, et le condensateur C3 est associé à un transistor K2 qui peut aussi être un transistor IGBT de type NPN et qui est également muni d'une carte de commande CC2.

La carte CC1 comporte deux entrées qui constituent ensemble une entrée différentielle et qui sont respectivement reliées aux bornes b1 et b2 de C2. La carte CC1 comporte aussi une sortie qui commande la base du transistor K1.

La borne a1 de C1 est également reliée au collecteur de K1 et la borne a2 de C1 est également reliée à la borne b2 de C2.

L'autre borne b1 de C2 est reliée à l'émetteur de K1 ainsi qu'à l'anode d'une diode D7 dont la cathode est reliée à l'une des bornes de l'inductance L2. L'autre borne de L2 est reliée à une borne c1 de C3 dont l'autre borne c2 est reliée à b2.

La carte CC2 comporte une entrée qui est reliée à des moyens M constituant l'horloge du système et permettant de commander, par l'intermédiaire de CC2, la fermeture et l'ouverture du commutateur que constitue le transistor K2 en fonction des exigences de charge-décharge du condensateur C3, la carte CC2 comportant également une sortie qui commande la base du transistor K2. L'émetteur de ce dernier est relié à la borne c2 du condensateur C3.

Dans le cas de la figure 2, le régulateur de tension 6 comprend le commutateur (transistor) K1 et le condensateur C2 et le générateur d'impulsions 8 comprend le commutateur K2, le condensateur C3 ainsi que des bobinages P1, S1 d'un transformateur, une inductance saturable L3 et des condensateurs C4 et C5 dont il sera question par la suite.

L'inductance L2 a une fonction de séparation entre le régulateur de tension 6 et le générateur d'impulsions 8.

La diode D7 permet un bon transfert d'énergie électrique de C2 vers C3 en évitant que cette énergie ne retourne à C2.

Le système représenté sur la figure 2 comprend également un transformateur T1 à trois enroulements ou bobinages P1, S1 et S2. Une borne du bobinage P1 est reliée au collecteur du transistor K2 et son autre borne est reliée à la borne c1 du condensateur C3 par l'intermédiaire d'une inductance saturable L5.

Cette dernière a une fonction d'aide à la commutation.

Le bobinage P1 joue le rôle d'un bobinage primaire tandis que le bobinage S1 joue le rôle d'un bobinage secondaire.

Les bornes de S1 sont respectivement reliées aux bornes d1 et d2 d'un condensateur C4. Les bornes e1 et e2 d'un autre condensateur C5 sont respectivement reliées aux électrodes du laser 12. De plus, les bornes d2 et e2 sont reliées l'une à l'autre et la borne d1 est reliée à la borne e1 par l'intermédiaire d'une inductance saturable L3.

Le bobinage S2 joue le rôle d'un bobinage secondaire vis-à-vis de S1. Une borne de S2 est reliée à l'anode d'une diode D9 dont la cathode est reliée à une borne f1 d'un condensateur C6. L'autre borne f2 de ce condensateur C6 est reliée à l'autre borne de S2.

Dans le cas de la figure 2, les moyens 10 pour dérouter, ou aiguiller, l'énergie réfléchie par le laser 12 comprennent le bobinage S2 et la diode D9 ; la récupération et le contrôle de cette énergie réfléchie sont obtenues grâce à un transistor K3, une diode D8, jouant le rôle d'une diode de roue libre, et une inductance L4.

Le transistor K3 est par exemple un transistor IGBT de type NPN. Il est muni d'une carte de commande CC3 qui commande ce transistor en tout ou rien. Cette carte comporte deux entrées qui forment ensemble une entrée différentielle et qui sont respectivement reliées aux bornes f1 et f2 de C6.

La carte CC3 comporte également une sortie qui commande la base du transistor K3. Le collecteur de ce dernier est relié à la borne f1 de C6 et l'émetteur du transistor K3 est relié à la cathode de la diode D8 dont l'anode est reliée à la borne f2 de C6.

De plus, la cathode de la diode D8 est reliée à une borne de l'inductance L4 dont l'autre borne est reliée à la borne a1 du condensateur C1 et l'anode de la diode D8 est également reliée à la borne a2 de ce condensateur C1.

On donne ci-après des indications sur le fonctionnement du système représenté sur la figure 2.

Lorsqu'une impulsion de déclenchement issue des moyens M provoque la fermeture du commutateur K2, le condensateur C3 transfère son énergie vers le condensateur C4 par oscillation de l'inductance de fuite du bobinage primaire P1 par rapport au bobinage secondaire S1 du transformateur T1. Dès la fin du transfert, c'est-à-dire dès que le courant à travers le transistor K2 s'annule, les moyens M commandent l'ouverture du commutateur que constitue ce transistor K2.

Tous les circuits compris entre K1 et le bobinage primaire P1 sont alors isolés des circuits situés en aval de P1 et ne sont donc pas perturbés par le comportement de ces circuits situés en aval de P1.

L'énergie de C4 est ensuite transférée au laser 12 à travers l'étage de compression magnétique formé par le condensateur C5 et par l'inductance saturable L3.

L'énergie réfléchie par le laser 12 revient charger le condensateur C4 avec une polarité inverse de la polarité initiale. Cette énergie réfléchie est alors transférée vers le condensateur C6 par oscillation de l'inductance de fuite de S1 par rapport à S2. L'énergie réfléchie reste stockée dans le condensateur C6 jusqu'à la fermeture du commutateur constitué par K3 qui permet le transfert de l'énergie stockée dans C6 vers C1, par oscillation avec l'inductance L4.

La carte CC3 de commande de K3 mesure la tension aux bornes de C6 et est pourvue d'un seuil réglable, tel que si cette tension est supérieure à ce seuil, la carte CC3 commande la fermeture de K3. Ainsi, il est possible de régler le seuil de façon à récupérer totalement l'énergie réfléchie par le laser.

Cependant, le seuil peut être réglé de façon à ne laisser passer qu'une partie déterminée de l'énergie réfléchie, stockée dans C4, pour permettre une démagnétisation complète de L3 ultérieure. Ceci est obtenu en provoquant l'ouverture de K3 avant que l'énergie stockée dans C6 ait été totalement transférée vers C1.

Le système décrit en faisant référence à la figure 2 permet de réduire la gigue des impulsions envoyées au laser 12 parce que la tension à laquelle est chargée C3 est maintenue constante d'un déclenchement de K2 à l'autre et que l'état de repos magnétique de L3 est rendu indépendant du comportement de la charge, c'est-à-dire du laser 12.

On notera, comme cela est d'ailleurs indiqué de façon classique par des points sur la figure 2, que les sens respectifs des bobinages de P1, S1 et S2 sont tels que les inductions correspondantes soient dans le même sens.

Les cartes CC1 et CC3 sont du genre de celles qui sont utilisées dans les alimentations électriques à découpage pour commander les transistors de puissance de telles alimentations. La carte CC2 assure la mise en forme des signaux issus des moyens M pour commander en tout ou rien le transistor K2.

On a indiqué plus haut que K1, K2 et K3 pouvaient être des transistors IGBT. Cependant l'un quelconque de ces transistors pourrait être remplacé par tout autre commutateur approprié tel qu'un thyristor GTO par exemple dont l'anode, la cathode et la gâchette seraient respectivement connectées comme le collecteur, l'émetteur et la base de ce transistor.

Dans une variante de réalisation, on utilise une pluralité d'étages de compression magnétique au lieu d'un seul : on rajoute par exemple à l'étage L3, C5 un étage supplémentaire de compression magnétique comportant une inductance saturable L6 (figure 3) et un condensateur C7 ; le laser 12 est, dans ce cas, monté entre les bornes g1 et g2 de C7, la borne g2 est reliée à la borne e2 de C5 et la borne g1 est reliée à la borne e1 de C5 par l'intermédiaire de l'inductance saturable L6.

## Revendications

1. Système d'alimentation électrique impulsionnelle d'une charge (12), ce système comprenant :
- un générateur (8) d'impulsions électriques, prévu pour fournir ces impulsions à la charge, et
- des moyens (2, 6) d'alimentation électrique continue du générateur,
système caractérisé en ce que le générateur (8) comprend :
- des premiers moyens (C3) d'accumulation d'énergie électrique, qui sont chargés en énergie électrique par les moyens d'alimentation électrique continue,
- des premiers moyens de commutation (K2) dont la fermeture provoque la décharge des premiers moyens (C3) d'accumulation d'énergie électrique et que l'on ouvre à la fin de cette décharge,
- un transformateur (T1) comportant :
. un premier bobinage (P1) relié aux premiers moyens (C3) d'accumulation d'énergie électrique par l'intermédiaire des premiers moyens (K2) de commutation, et
. un deuxième bobinage (S1) ainsi qu'un troisième bobinage (S2), et
- des deuxièmes moyens (C4) d'accumulation d'énergie électrique qui sont reliés, d'un côté, au deuxième bobinage (S1) et, de l'autre, à la charge (12), les premier et deuxième bobinages étant couplés pour permettre le transfert de l'énergie électrique des premiers moyens d'accumulation (C3) vers les deuxièmes moyens d'accumulation (C4) lors de la fermeture des premiers moyens de commutation (K2),
et caractérisé en ce que le système comprend en outre des moyens (10) prévus pour dérouter l'énergie électrique susceptible d'être réfléchie par la charge après que celle-ci a reçu une impulsion électrique de la part du générateur, de façon que l'énergie électrique réfléchie prenne un chemin différent de celui qu'a suivi cette impulsion et ne retourne pas directement au générateur, les moyens prévus pour détourner l'énergie électrique réfléchie comprenant le troisième bobinage (S2), ce dernier étant prévu pour capter, par couplage avec le deuxième bobinage (S1), l'énergie électrique réfléchie, accumulée dans les deuxièmes moyens (C4) d'accumulation d'énergie électrique.

2. Système selon la revendication 1, caractérisé en ce qu'il comprend en outre des moyens auxiliaires (14), prévus pour récupérer, au moins en partie, l'énergie électrique réfléchie et déroutée.

3. Système selon la revendication 2, caractérisé en ce que les moyens d'alimentation électrique continue comprennent :
- une source (2) de tension électrique continue, et
- des moyens (6) de régulation de cette tension, qui alimentent le générateur (8),
et en ce que les moyens auxiliaires (14) sont en outre prévus pour transférer l'énergie électrique récupérée vers la source de tension.

4. Système selon la revendication 2, caractérisé en ce que les moyens auxiliaires comprennent des troisièmes moyens (C6) d'accumulation d'énergie électrique qui sont reliés au troisième bobinage (S2).

5. Système selon les revendications 3 et 4, caractérisé en ce que les moyens auxiliaires comprennent en outre des deuxièmes moyens (K3) de commutation par l'intermédaire desquels les troisièmes moyens d'accumulation (C6) sont reliés à la source de tension.

6. Système selon la revendication 5, caractérisé en ce que les premiers et deuxièmes moyens de commutation (K2, K3) sont des dispositifs semiconducteurs de commutation.

7. Système selon l'une quelconque des revendications 1 à 6, caractérisé en ce que le générateur comprend en outre des moyens (L3, C5, L6, C7) de compression magnétique par l'intermédiaire desquels la charge (12) reçoit l'impulsion électrique.

8. Système selon l'une quelconque des revendications 1 à 6, caractérisé en ce que le générateur comprend en outre des moyens (L3, C5, L6, C7) de compression magnétique qui sont reliés, d'un côté, aux deuxièmes moyens (C4) d'accumulation d'énergie électrique et, de l'autre, à la charge (12), et par l'intermédiaire desquels cette charge (12) reçoit l'impulsion électrique.

9. Système selon l'une quelconque des revendications 1 à 8, caractérisé en ce que la charge (12) est un laser à vapeur métallique.

## Patentansprüche

1. Impuls-Stromversorgungssystem für eine Last (12), umfassend:
- einen elektrischen Impulsgenerator (8), vorgesehen, um diese Impulse an die Last zu liefern, und
- Gleichstromversorgungseinrichtungen (2, 6) für den Generator,
System, **dadurch gekennzeichnet**, daß der Generator (8) umfaßt:
- erste Speichereinrichtungen (C3) für elektrische Energie, die durch Gleichstromversorgungseinrichtungen mit elektrischer Energie geladen werden,
- erste Umschalteinrichtungen (K2), deren Schließung die Entladung der ersten elektrischen Energiespeichereinrichtungen (C3) bewirkt, und die man am Ende dieser Entladung öffnet,
- einen Transformator (T1), umfassend:
. eine erste Bewicklung (P1), verbunden mit den ersten elektrischen Energiespeicherungseinrichtungen (C3) über erste Umschalteinrichtungen (K2), und
. eine zweite Bewicklung (S1), sowie eine dritte Bewicklung (S2), und
- zweite elektrische Energiespeichereinrichtungen (C4), die einerseits verbunden sind mit der zweiten Bewicklung (S1) und andererseits mit einer Last (12), wobei die erste und die zweite Bewicklung gekoppelt sind, um während der Schließung der ersten Umschalteinrichtungen (K2) den Transfer der elektrischen Energie der ersten Speichereinrichtungen (C3) zu den zweiten Speichereinrichtungen (C4) zu ermöglichen,
und **dadurch gekennzeichnet**, daß das System außerdem Einrichtungen (10) umfaßt, die vorgesehen sind, um die elektrische Energie umzuleiten, die durch die Last reflektiert wird, nachdem diese vom Generator einen elektrischen Impuls erhalten hat, so daß die reflektierte elektrische Energie einen anderen Weg nimmt als den, dem der Impuls gefolgt ist, und nicht direkt zum Generator zurückkehrt, wobei die Einrichtungen, die vorgesehen sind, um die reflektierte elektrische Energie umzuleiten eine dritte Bewicklung (S2) umfassen, wobei diese letztere vorgesehen ist um, durch Kopplung mit der zweiten Bewicklung (S1), die reflektierte elektrische Energie aufzufangen, die gespeichert ist in diesen zweiten elektrischen Energiespeichereinrichtungen (C4).

2. System nach Anspruch 1, dadurch gekennzeichnet, daß es außerdem Hilfseinichtungen (14) umfaßt, die vorgesehen sind, um wenigstens partiell die reflektierte und umgeleitete Energie zurückzugewinnen.

3. System nach Anspruch 2, dadurch gekennzeichnet, daß die elektrischen Gleichstomversorgungseinrichtungen umfassen:
- eine Gleichspannungsquelle (2), und
- Regeleinrichtungen (6) für diese Spannung, die den Generator (8) speisen,
und dadurch, daß diese Hilfseinrichtungen (14) außerdem vorgesehen sind, um die zurückgewonnene elektrische Energie zu der Spannungsquelle zu übertragen.

4. System nach Anspruch 2, dadurch gekennzeichnet, daß die Hilfseinrichtungen dritte elektrische Speichereinrichtungen (C6) umfassen, die mit der dritten Bewicklung (S2) verbunden sind.

5. System nach den Ansprüchen 3 und 4, dadurch gekennzeichnet, daß die Hilfseinrichtungen außerdem zweite Umschalteinrichtungen (K3) umfassen, über die die dritten Speichereinrichtungen (C6) mit der Spannungsquelle verbunden sind.

6. System nach Anspruch 5, dadurch gekennzeichnet, daß die ersten und zweiten Umschalteinrichtungen (K2, K3) Halbleiter-Umschalteinrichtungen sind.

7. System nach einem der Ansprüche 1 bis 6, dadurch gekennzeichnet, daß der Generator außerdem magnetische Kompressionseinrichtungen (L3, C5, L6, C7) umfaßt, mittels der die Last (12) den elektrischen Impuls erhält.

8. System nach einem der Ansprüche 1 bis 6, dadurch gekennzeichnet, daß der Generator außerdem magnetische Kompressionseinrichtungen (L3, C5, L6, C7) umfaßt, die einerseits mit den zweiten elektrischen Energiespeichereinrichtungen (C4) verbunden sind und andererseits mit der Last (12), und mittels der diese Last (12) den elektrischen Impuls erhält.

9. System nach einem der Ansprüche 1 bis 8, dadurch gekennzeichnet, daß die Last (12) ein Metalldampflaser ist.

## Claims

1. Pulse-type electric supply system for a load (12) incorporating an electric pulse generator (8) for supplying said pulses to the load and direct current electric supply means (2,6) for the generator and the generator (8) comprises first electric power accumulation means (C3), which are charged with electric power by direct current electric supply means, first switching means (K2), whose closure causes the discharge of the first electric power accumulation means (C3) and which are opened at the end of said discharge, a transformer (T1) incorporating a first coil (P1) connected to the first electric power accumullation means (C3) via said first switching means (K2) and a second coil (S1), as well as a third coil (S2) and second electric power accumulation means (C4) connected on the one hand to the second coil (S1) and on the other hand to the load (12), the first and second coils being coupled so as to permit the transfer of the electric power of the first accumulation means (C3) to the second accumulation means (C4) during the closure of the first switching means (K2), characterized in that the system also comprises means (10) for diverting the electric power liable to be reflected by the load after the latter has received an electric pulse from the generator, so that the reflected electric power takes a path different from that folloowed by said pulse and does not directly return to the generator and in that the means for diverting the reflected electric power incorporate the third coil (S2), the latter serving to intercept, by coupling with the second coil (S1), the reflected electric power accumulated in the second electric power accumulation means (C4).

2. System according to claim 1, characterized in that it also comprises auxiliary means (14) for the at least partial recovery of the reflected and diverted electric power.

3. System according to claim 2, characterized in that the direct current electric supply means comprise a d.c. voltage source (2) and means (6) for regulating said voltage, said means for regulating said voltage supplying the generator (8) and in that the auxiliary means (14) are also provided for transferring the recovered electric power to the voltage source.

4. System according to claim 2, characterized in that the auxiliary means incorporate third electric power accumulation means (C6) connected to the third coil (S2).

5. System according to claims 3 and 4, characterized in that the auxiliary means also incorporate second switching means (K3) via which the third accumulation means (C6) are connected to the voltage source.

6. System according to claim 5, characterized in that the first and second switching means (K2,K3) are semiconductor switching devices.

7. System according to any one of the claims 1 to 6, characterized in that the generator also comprises magnetic compression means (L3, C5, L6, C7) via which the load (12) receives the electric pulse.

8. System according to any one of the claims 1 to 6, characterized in that the generator also comprises magnetic compression means (L3, C5, L6, C7) connected on the one hand to the second electric power accumulation means (C4) and on the other to the load (12) and via which said load (12) receives the electric pulse.

9. System according to any one of the claims 1 to 8, characterized in that the load (12) is a metal vapour laser.
